(19) Europäisches Patentamt

European Patent Office

Office européen des brevets

(11) EP 0 680 613 B1

(12) **EUROPÄISCHE PATENTSCHRIFT**

(45) Veröffentlichungstag und Bekanntmachung des Hinweises auf die Patenterteilung:
**25.02.2004 Patentblatt 2004/09**

(21) Anmeldenummer: **95900629.7**

(22) Anmeldetag: **17.11.1994**

(51) Int Cl.⁷: **G01R 31/36**

(86) Internationale Anmeldenummer:
**PCT/DE1994/001349**

(87) Internationale Veröffentlichungsnummer:
**WO 1995/014239 (26.05.1995 Gazette 1995/22)**

(54) **VERFAHREN ZUR ERMITTLUNG DES LADEZUSTANDES EINER BATTERIE, INSBESONDERE EINER FAHRZEUG-STARTERBATTERIE**

METHOD OF DETERMINING THE CHARGE STATUS OF A BATTERY, IN PARTICULAR A VEHICLE STARTER BATTERY

PROCEDE DE DETERMINATION DE L'ETAT DE CHARGE D'UNE BATTERIE, EN PARTICULIER D'UNE BATTERIE DE DEMARRAGE DE VEHICULE

(84) Benannte Vertragsstaaten:
**DE FR GB IT**

(30) Priorität: **19.11.1993 DE 4339568**

(43) Veröffentlichungstag der Anmeldung:
**08.11.1995 Patentblatt 1995/45**

(73) Patentinhaber: **ROBERT BOSCH GMBH**
**70442 Stuttgart (DE)**

(72) Erfinder: **RICHTER, Gerolf**
**D-3200 Hildesheim (DE)**

(56) Entgegenhaltungen:
EP-A- 0 423 483     EP-A- 0 560 468
WO-A-92/15893     DE-A- 3 808 559

## Beschreibung

Stand der Technik

Die Batterie in einem Kraftfahrzeug, die zur Versorgung der elektrischen Systeme und besonders auch zur Versorgung des Starters dient, wird mit Hilfe eines vom Motor angetriebenen Drehstromgenerators, dessen Ausgangsspannung in geeigneter Weise geregelt wird, geladen. Da die Batterie eine Vielzahl von Verbrauchern versorgen muß, kann unter ungünstigen Betriebsbedingungen, beispielsweise bei tiefen Temperaturen und ungünstigen Fahrverhältnissen die Batterie soweit entladen werden, daß eine zuverlässige Spannungsversorgung nicht mehr gewährleistet ist. Besonders der Start des Motors kann in diesem Fall problematisch werden, da der Anlasser eine beträchtliche elektrische Energie benötigt.

Es ist daher bekannt, den noch verfügbaren Energieinhalt der Batterie zu ermitteln. Dazu sind mehrere unterschiedliche Methoden durchgeführt worden, eine dieser Methoden besteht in der meßtechnischen Ermittlung der elektrochemischen Batteriezustandsgröße Säuredichte und der sich daraus ableitenden Ruhespannung. Diese Methode ist jedoch unzuverlässig, da bei einer in Betrieb befindlichen Batterie Diffusionsausgleichzeiten und Temperaturänderungen berücksichtigt werden müßten.

Aus der EP-A-0 560 468 ist ein Verfahren zur Ermittlung des Ladezustandes für eine Batterie bekannt, bei dem der Batteriestrom, und die Ruhespannung der Batterie gemessen wird. Der Batteriestrom wird in verschiedenen Zeiten gemessen, entweder als Lade- oder Entladestrom. Aus den Messwerten schließt eine Recheneinrichtung unter Berücksichtigung von Korrekturfunktionen für die Batteriespannung auf den Ladezustand der Batterie. Ein Zeitraum, während dem die Batterie noch einen vorgebbaren Strom liefern kann, wird nicht ermittelt.

Die WO-A-92 15893 beschreibt ein Verfahren zur Ladezustandsanzeige, bei dem eine Strommessung im Lastkreis einer Batterie, deren Ladezustand ermittelt werden soll, erfolgt. Durch Integration des fließenden Stroms und durch Berücksichtigung verschiedener Korrekturverfahren kann eine Verbesserung der Genauigkeit bei der Bestimmung des Ladezustandes erhalten werden.

Aus der DE-A-38 08 559 ist ein Verfahren zur Überwachung der Leistungsgrenze einer Starterbatterie bekannt, bei dem die Klemmenspannung der Batterie, der Lade- und Entladestrom sowie die Temperatur gemessen werden und bei der Überwachung berücksichtigt werden. Der Strom wird bilanziert und zusätzlich das Erreichen einer Mindestspannung überwacht. Sinkt die Klemmenspannung der Batterie für eine vorgebbare Zeit unter diese Mindestspannung, wird eine Warnung abgegeben, die wieder aufgehoben wird, wenn zugeflossene Ladungsmenge um einen vorgegebenen Betrag größer ist als die abgeflossene Ladungsmenge.

Eine weitere Methode, die jedoch nur im stationären Zustand brauchbar ist, besteht darin, den Innenwiderstand der Batterie zu bestimmen, der als Maß für den Ladezustand dienen kann. Der Innenwiderstand kann dabei durch die Beobachtung der Klemmenspannung der Batterie während der Beaufschlagung mit einem Belastungsimpuls ermittelt werden.

Eine weitere Möglichkeit besteht darin, den Ladezustand einer Batterie, beispielsweise der Starterbatterie eines Kraftfahrzeuges zu ermitteln, indem fortlaufend der Batteriestrom gemessen wird und daraus durch Integrieren über der Zeit die der Batterie entnommene Ladung ermittelt wird. Diese Vorgehensweise wird in der DE-OS 35 20 985 beschrieben. Gemäß dem dabei beschriebenen Verfahren wird zusätzlich nach Abschalten des Fahrzeugmotors die Batteriespannung gemessen und aus dem Absinken gegenüber der Spannung bei vollgeladener Batterie und der für den stromlosen Zustand errechneten entnommenen Ladung eine fiktive Batteriekapazität berechnet. Aus dieser fiktiven Batteriekapazität wird dann der Ladezustand ermittelt.

Diese Methode ist jedoch immer noch nicht zuverlässig genug, da alle Batteriesysteme die unangenehme Eigenschaft besitzen, daß die Kapazitätsänderung und damit die noch zur Verfügung stehende Restkapazität bezogen auf eine definierte Entladeschlußspannung im stärkeren Maße von einer Vielzahl von Größen abhängt. Diese Großen sind beispielsweise die Größe des entnommenen bzw. zugeführten Stromes, die Temperatur, das Batteriealter sowie der bereits eingetretene Batterieladestatus.

Vorteile der Erfindung

Das erfindungsgemäße Verfahren mit den Merkmalen des Hauptanspruchs hat demgegenüber den Vorteil, daß eine sehr zuverlässige Aussage über den vorliegenden Ladezustand der Batterie möglich ist.

Erzielt wird dieser Vorteil, indem eine genaue Bilanzierung des entnommenen sowie des zugeführten Stromes durchgeführt wird und Korrekturen durchgeführt werden, die die Stärke des Stromes, die Temperatur sowie das Batteriealter berücksichtigen. Besonders vorteilhaft ist, daß die Korrekturen mit Hilfe geeigneter Funktionen in einer Recheneinrichtung durchführbar sind. Dabei wird eine Zeitspanne ermittelt, die eine genaue Aussage bezüglich des Batterieladezustandes darstellt. Diese Zeitspanne gibt an, wie lange die Batterie noch einen vorgebbaren Strom liefern kann.

Weitere Vorteile der Erfindung werden mit Hilfe der in den Unteransprüchen angegebenen Maßnahmen erzielt.

Eine vorteilhafte Maßnahme besteht darin, die Zeitspanne, die den Ladezustand der Batterie charakterisiert, als Basis zur Regelung des Generators heranzuziehen. Es kann weiterhin in vorteilhafter Weise eine Anzeige erfolgen, wenn die ermittelte Zeit unter einen in geeigneter Weise festlegbaren Schwellwert sinkt und beispielsweise anzuzeigen, wenn die noch vorhandene Batterieladung nicht mehr für eine bestimmte Mindestanzahl von Startversuchen ausreicht.

Zeichnung

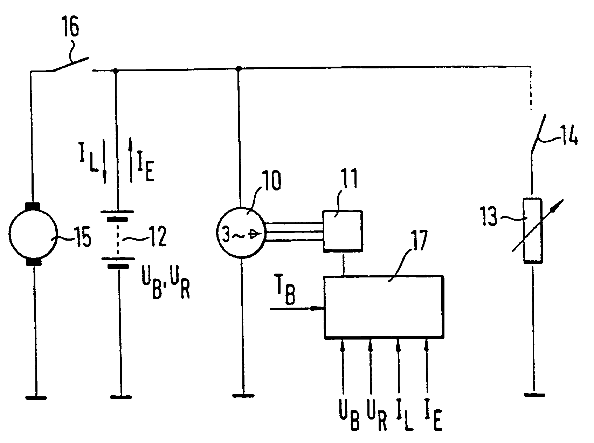

Ein Ausführungsbeispiel der Erfindung ist in der Zeichnung dargestellt und wird in der nachfolgenden Beschreibung näher erläutert. Es ist dabei in der einzigen Figur ein Fahrzeugbordnetz mit den erfindungswesentlichen Größen schematisch dargestellt.

Beschreibung des Ausführungsbeispiels

Das in der Figur dargestellte Fahrzeugbordnetz umfaßt einen Generator 10, dessen Ausgangsspannung vom Spannungsregler 11 geregelt wird, eine Batterie 12, die vom Generator geladen wird sowie die eigentlichen Bordnetzverbraucher 13, die über Schaltmittel 14 an die Versorgungsspannung gelegt werden können.

Mit 15 ist der Starter bezeichnet, der über den Zündschalter 16 mit der Batterie verbindbar ist. Mit 17 ist eine Recheneinrichtung, beispielsweise eine integrierte Schaltung oder ein Steuergerät bezeichnet, dem verschiedene Informationen zugeführt werden und in dem das erfindungsgemäße Verfahren zur Ermittlung des Ladezustandes der Batterie 12 abläuft.

Als der Recheneinrichtung 17 zugeführte Größen sind angegeben: Die Batteriespannung $U_B$, die Ruhespannung $U_R$, der Ladestrom $I_L$, der Entladestrom $I_E$ sowie die Temperatur der Batterie $T_B$.

Die erwähnten Größen werden mit Hilfe geeigneter Schaltungen bzw. geeigneter Sensoren gemessen. Der Zeitpunkt und die Dauer der Messung wird von der Recheneinrichtung 17 selbst festgelegt. Die Recheneinrichtung 17 umfaßt geeignete Mittel zur Abspeicherung von Daten sowie geeignete Mittel zur Messung von Zeiten.

In der Recheneinrichtung 17 läuft die eigentliche Batterie-Ladezustandsermittlung ab. Es wird dabei ausgehend von einer Strombilanzierung also von der Betrachtung der in die Batterie fließenden Ladeströme und der aus der Batterie fließenden Entladeströme eine Ladezustandsermittlung durchgeführt, wobei zusätzliche Modell- bzw. Korrekturfunktionen berücksichtigt werden. Die gefundenen Ergebnisse werden weiterhin mit Hilfe der nach langen Unterbrechungen ermittelten Ruhespannung der Batterie korrigiert.

Die im folgenden beschriebene Batterie-Ladezustandsermittlung gilt insbesondere für das Modell einer wartungsfreien Blei/Säurestarterbatterie in einem Kraftfahrzeug mit etwa identischen Plattenabmessungen und einer genormten Säuredichte, sodaß der Wasserverbrauch während der mittleren zu erwartenden Lebensdauer vernachlässigbar gering ist und nicht zu Ungenauigkeiten bei der Ladezustandsermittlung führt.

Der zu berücksichtigende Alterungsprozeß ist im wesentlichen vom Alter der Batterie und von der Temperatur abhängig, denn unter normalen Bedingungen die für eine in einem Kraftfahrzeug eingebaute Batterie gelten, verschleißt die Batterie fast unabhängig von der Fahrerleistung bzw. der Häufigkeit der Startversuche. Der Einfluß der mittleren Betriebstemperatur, der nicht zu vernachlässigen ist, wird empirisch erfaßt. Damit das Verfahren zur Ladezustandsbestimmung ablaufen kann, sind verschiedene Messungen erforderlich. Es werden daher im Betriebsfall die Ladeströme $I_L$ bzw. die Entladeströme $I_E$ beispielsweise mittels einer Stromzange gemessen, wobei diese Messungen innerhalb von Zeitintervallen, die beispielsweise nur Sekundenbruchteile dauern, erfolgen.

Während längerer Ruhepausen wird die Ruhespannung $U_R$ der Batterie 12 gemessen. Für die Messung der Batteriespannung $U_B$ sind heute geläufige Schaltungen einsetzbar. Die Messung der Batterietemperatur $T_B$ erfolgt laufend, sie wird einerseits zur Ruhespannungskorrektur benötigt und andererseits zur Ermittlung der aktuell noch zur Verfügung stehenden Kapazität und zur Beschreibung des Batteriealters.

Die Meßergebnisse werden über geeignete Verbindungen zur Recheneinrichtung 17 geführt. Sie sind dort zwischenspeicherbar und stehen der Recheneinrichtung 17 zur Auswertung zur Verfügung.

Die Verknüpfung zwischen den gemessenen Größen und den Korrekturmaßnahmen läßt sich folgendermaßen darstellen:

1. Entladen

Im Zeitintervall $\Delta t_{Ei}$ wird der Entladestrom $I_E$ gemessen. Da der mittlere Entladestrom für einen PKW etwa der dreistündige Strom $I_{3E}$ ist (Strom, bei dem nach dreistündiger Entladezeit bei Raumtemperatur eine Entladeschlußspannung von U = 10,5 V erreicht wird), gilt als Bezugsgröße auch die Kapazität $K_3$. Der Index 3 steht für dreistündig. Als batterietypische Eingabegröße muß deshalb auch $I_{3E0}$ zur Verfügung stehen, der Index 0 steht für "neue Batterie". Der Strom $I_{3E0}$ wird bei neuer Batterie gemessen. Für eine ideale Batterie gilt demzufolge im iten Meßintervall:

$$\Delta t_{3i} * I_{3E} = \Delta t_{Ei} * I_E$$

bzw. für die, von der noch zur Verfügung stehenden dreistündigen Restzeit $t_{3i}$, "abgebaute" Zeit gilt:

$$\Delta t_{3i} = \Delta t_{Ei} * \frac{I_E}{I_{3E}}$$

Wie bereits erwähnt, muß dieses Zeitintervall für alle realen Batterie-Syteme eine Korrektur erfahren.

Im Falle der Blei/Säure-Batterie haben sich die empirischen Gleichungen nach Peukert oder Liebenow bewährt. Die folgenden Gleichungen zeigen den Einfluß dieser Korrekturen.

a) Nach Peukert gilt:

$$\Delta t_{3i} = \Delta t_{Ei} * \frac{I_E}{I_{3E}} \left(\frac{I_E}{I_{3E}}\right)^{n_E}$$

mit: $n_E \approx 0{,}2$ für eine Starter-Batterie

b) Nach Liebenow gilt:

$$\Delta t_{3i} = \Delta t_{Ei} * \frac{I_E}{I_{3E}} (1 + \gamma * I_{Ei} \sqrt{\Delta t_{Ei}})$$

für $I_E > I_{3E}$

Die Peukert-Korrektur zeigt eine besonders gute Übereinstimmung mit Meßwerten für mittlere Entladeströme, wo hingegen die Liebenow-Gleichung eine befriedigende Näherung über den gesamten möglichen Entladestrombereich mit obiger Einschränkung gewährleistet.

2. Laden

Der Ladegewinn einer Starter-Batterie im Intervall $\Delta t_{Li}$ muß mit einem vom Ladestatus abhängigen Ladewirkungsgrad $\eta_L$ multipliziert werden. Da Ladestrom irreversibel nur durch Gasung verlorengehen kann, ist für moderne, wartungsfreie Batterien $\eta_L = 1$ zu setzen, insbesondere, wenn eine periodische Ruhespannungskontrolle, bei der die Spannung $U_R$ gemessen wird, erfolgt. Damit ergibt sich für den Gewinn an dreistündiger Entladezeit im Meßintervall:

$$\Delta t_{3i} = \Delta t_{Li} * \frac{I_L}{I_{3L}}$$

3. Bilanz von Laden und Entladen:

Die aktuelle (im iten Intervall) zur Verfügung stehende Zeit $t_{3i}$ bei Entladung mit Strom $I_{3E}$ unter Normalbedingungen (Raumtemperatur) bis zur Entladeschlußspannung von 10,5 V beträgt

$$t_{3i} = t_3 + \Sigma \Delta t_{3i} \text{ (Laden +, Entladen -)}$$

mit $t_3 = 3$ h und $0 \le t_{3i} \le t_3$

4. Berücksichtigung des Batteriealters und der durchschnittlichen Temperaturbelastung:

Die für eine neue Batterie charakteristische Eingabegröße für das Rechenprogramm ist der dreistündige Entladestrom $I_{3EO}$. Laborexperimente sowie durchgeführte Fahrversuche haben gezigt, daß sich dieser Wert, abhängig vom Batteriealter und der durchschnittlichen Temperaturbelastung, kontinuierlich verringert und zum Zeitpunkt (Alter) t den Betrag von $I_{3E}$ aufweist. Es gilt mit guter Übereinstimmung

$$I_{3E} = I_{3EO} [\beta + (1-\beta) e^{-t/\tau}]$$

mit $\beta = 0{,}5$ als unterste Grenze für einen erfolgreichen Kaltstart.

Die Zeitkonstante für den Alterungsprozeß ist in erster Linie temperaturabhängig, bedingt durch die Korrosion der positiven Gitter. Dieser Vorgang ist gut mit folgendem Zusammenhang zu beschreiben

$$\tau = \tau_0 \cdot 2^{-(T-20°C)/10°C}$$

und $\tau_0 \approx 2$ Jahre.

Unter diesen gegebenen Voraussetzungen muß die Änderung von $I_{3E}$ innerhalb des Zeitintervalls $\Delta t_i$ ermittelt werden.

Es ergibt sich zum Zeitpunkt $t = \Sigma \Delta t_i$ eine dimensionslose Zeit

$$t^* = \frac{\Sigma \Delta t_i}{\tau_i}$$

und damit für

$$I_{3E} = -I_{3EO} \frac{\Delta t_i}{\tau_i} (1-\beta) e^{-t^*}$$

mit:

$$\tau_i = \frac{\displaystyle\sum_{j=1}^{1} \tau_j}{i}$$

Somit erhält man als Berechnungsgleichung für das aktuelle $I_{3E}$

$$i_{3E} = I_{3EO} - \Sigma\ I_{3EO}\ \frac{\Delta t_i}{\tau_i}(1-\beta)\ e^{-t^*}$$

Der so gewonnene dreistündige Strom repräsentiert die altersabhängige entnehmbare dreistündige Kapazität einer vollgeladenen Batterie und ist die Basisgröße in den Gleichungen von Peukert bzw. Liebenow.

5. Verfügbare Kapazität bei gegebener Elektrolyttemperatur:

Wie bereits erwähnt, bezieht sich die "Normalzeit" $t_{3i}$ auf den Entladungsfall einer Batterie mit einer Elektrolyttemperatur von 25° C. Mit sinkender Temperatur wird allerdings die tatsächlich verfügbar Zeit $t_{3iV}$ für einen dreistündigen Strom immer geringer.

Es hat sich gezeigt, daß die Temperaturabhängigkeit in dem interessierenden Temperaturintervall von -20° bis + 40° C in guter Näherung als linear angenommen werden kann. Dies gilt insbesondere für Ströme in der hier betrachteten Größenordnung

$$t_{3iV} = t_{3i}\ [1 + 0,006\ (T-300)]\ \text{mit T in K}$$

Diese Zeit würde sich in der Praxis z.B. zur Steuerung bzw. Regelung der Generatorleistung mittels eines entsprechenden Spannungsreglers in einem Pkw-Bordnetz eignen. Die Regelkriterien können dann der Erregerstrom und/oder die Spannung sein.

Hinsichtlich diverser Alarmkriterien, wie z.B. für die Information: "Achtung, noch drei Starts unter gegebenen Bedingungen möglich", muß in der Recheneinrichtung ein ständiger Vergleich zwischen einem motor- und starterspezifischen Kennfeld bezüglich erforderlichem Strom und Startzeit mit den entsprechenden Werten aus der Ladezustandsinformation durchgeführt werden.

Die Korrekturen nach 4. bzw. 5. liefern Berechnungsanweisungen für $I_{3E}$. Die zugehörigen Gleichungen werden als Berechnungsvorschriften für $I_{3E}$ in die Gleichungen nach 1.a) und 1.b) eingesetzt. Die Bilanzgleichung für $t_{3i}$ mit den zuvor eingesetzten Beziehungen für $I_{3E}$ ist das gewünschte Kriterium für den Ladezustand. Es ist ein Zeitraum, der die noch zur Verfügung stehende Restzeit charakterisiert.

Die Ladezustandsermittlung muß nicht unbedingt ausgehend von dreistündiger Entladezeit erfolgen, auch eine Entladezeit von ca. 2 bis 6 Stunden wäre möglich.

## Patentansprüche

1. Verfahren zur Ermittlung des Ladezustandes einer Batterie, insbesondere einer Fahrzeug-Starterbatterie, bei dem bei Erkennen bestimmter Betriebszustände der Batteriestrom und die Ruhespannung gemessen werden und aus den Meßwerten mittels einer Recheneinrichtung auf den Ladezustand geschlossen wird, wobei die ermittelten Meßgrößen mit Korrekturfunktionen verknüpft werden, die abhängig wenigstens von der Batterietemperatur gebildet werden, wobei der während eines ersten Zeitraumes gemessene Entladestrom und der während eines zweiten Zeitraumes gemessene Ladestrom zueinander in Bezug gesetzt werden, **dadurch gekennzeichnet, dass** daraus ein dritter Zeitraum ermittelt wird, der die noch zur Verfügung stehende Restzeit charakterisiert, die angibt, wie lange die Batterie noch einen vorgebbaren Strom liefern kann.

2. Verfahren nach Anspruch 1, **dadurch gekennzeichnet, dass** bei der Ermittlung des dritten Zeitraumes die während längerer Ruhepausen gemessene Ruhespannung der Batterie zur Ruhespannungskorrektur berücksichtigt wird.

3. Verfahren nach einem der vorhergehenden Ansprüche, **dadurch gekennzeichnet, dass** aus dem dritten Zeitraum ein Entladestrom ermittelt wird, wobei berücksichtigt wird, dass der Entladestrom vom dritten Zeitraum exponentiell abhängt.

4. Verfahren nach einem der vorhergehenden Ansprüche, **dadurch gekennzeichnet, dass** Alarmmittel ausgelöst werden, wenn die ermittelte Restzeit kleiner ist als ein vorgebbarer Schwellwert.

5. Verfahren nach Anspruch 4, **dadurch gekennzeichnet, dass** der Schwellwert so festgelegt wird, dass noch eine Mindestzahl von Startversuchen durchführbar ist.

6. Verfahren nach einem der vorhergehenden Ansprüche, **dadurch gekennzeichnet, dass** aus dem ermittelten dritten Zeitintervall die zur Verfügung stehende Kapazität der Batterie für eine vorgebbare Temperatur berechnet wird.

7. Verfahren nach einem der vorhergehenden Ansprüche, **dadurch gekennzeichnet, dass** die Restzeit als Grundlage für die Regelung eines Generators, mittels eines Spannungsreglers, in einem Fahrzeug-Bordnetz verwendet wird.

## Claims

1. Method for determining the charge state of a battery, in particular a vehicle starter battery, in which in conjunction with detection of specific operating states the battery current and the open-circuit voltage are measured and a conclusion is drawn on the charge state from the measured values by means of a computing device, the measured variables determined being combined by means of correction functions which are formed in dependence at least on the battery temperature, the mutual relationship between a discharging current measured during a first period and the charging current measured during a second period being established, **characterized in that** there is determined therefrom a third time period which characterizes the residual time which is still available and specifies how long the battery can still deliver a prescribable current.

2. Method according to Claim 1, **characterized in that** when determining the third period the open-circuit voltage of the battery, which is measured during longer rest periods, is taken into account for correction of the open-circuit voltage.

3. Method according to one of the preceding claims, **characterized in that** a discharging current is determined from the third period, it being taken into account that the discharging current depends exponentially on the third period.

4. Method according to one of the preceding claims, **characterized in that** alarm means are triggered when the residual time determined is shorter than a prescribable threshold value.

5. Method according to Claim 4, **characterized in that** the threshold value is fixed in such a way that it is still possible to carry out a minimum number of starting tests.

6. Method according to one of the preceding claims, **characterized in that** the available capacity of the battery is computed for a prescribable temperature from the third time interval determined.

7. Method according to one of the preceding claims, **characterized in that** the residual time is used as the basis for regulating a generator, by means of a voltage regulator, in a vehicle electrical system.

## Revendications

1. Procédé de détermination de l'état de charge d'une batterie, en particulier d'une batterie de démarrage d'un véhicule, dans lequel :

   - quand certains états de fonctionnement sont reconnus, l'intensité du courant de batterie et la tension de celui-ci sont mesurés et des valeurs mesurées, un dispositif calculateur déduit l'état de charge de la batterie,
   - les grandeurs mesurées sont corrélées à des fonctions de correction formées en fonction au moins de la température de la batterie,
   - l'intensité de décharge mesurée pendant un premier intervalle de temps et l'intensité de charge mesurée pendant un deuxième intervalle de temps sont mises en rapport l'une par rapport à l'autre,

   **caractérisé en ce qu'**
   on déduit de cela un troisième intervalle de temps qui caractérise le temps résiduel restant disponible, ce temps indiquant pendant combien de temps la batterie peut encore fournir une intensité prédéfinie.

2. Procédé selon la revendication 1,
   **caractérisé en ce que**
   quand on établit le troisième espace de temps, la tension de repos de la batterie, mesurée pendant d'assez longues périodes de repos, est prise en compte pour corriger la tension de repos.

3. Procédé selon la revendication 1 ou 2,
   **caractérisé en ce qu'**
   à partir du troisième intervalle de temps, on établit une intensité de décharge en tenant compte du fait que l'intensité de décharge dépend exponentiellement du troisième intervalle de temps.

4. Procédé selon l'une des revendications précédentes,
   **caractérisé en ce que**
   le moyen d'alarme est déclenché quand le temps résiduel déterminé est inférieur à une valeur de seuil prédéfinie.

5. Procédé selon la revendication 4,
   **caractérisé en ce que**
   la valeur de seuil est établie de manière à permettre que soit encore effectué un certain nombre d'essais de démarrage.

6. Procédé selon l'une des revendications précédentes,
   **caractérisé en ce qu'**
   à partir du troisième intervalle de temps déterminé, on calcule la capacité disponible que présente la batterie à une température prédéfinie.

7. Procédé selon l'une quelconque des revendications précédentes,
   **caractérisé en ce que**
   le temps résiduel est utilisé comme base de la régulation d'un générateur, assurée par un régulateur de tension dans le réseau de bord du véhicule.